# EUROPÄISCHE PATENTSCHRIFT

(11) **EP 3 317 906 B1**
(45) Veröffentlichungstag und Bekanntmachung des Hinweises auf die Patenterteilung: **25.11.2020**
(21) Anmeldenummer: 16731584.5
(22) Anmeldetag: 22.06.2016
(51) Int. Cl.: H01L 51/52

(54) **ORGANISCHES LICHTEMITTIERENDES BAUELEMENT UND VERFAHREN ZUR HERSTELLUNG EINES ORGANISCHEN LICHTEMITTIERENDEN BAUELEMENTS**
ORGANIC LIGHT-EMITTING COMPONENT AND METHOD FOR PRODUCING AN ORGANIC LIGHT-EMITTING COMPONENT
COMPOSANT ORGANIQUE ÉLECTROLUMINESCENT ET SON PROCÉDÉ DE FABRICATION

(30) Priorität: 03.07.2015 DE 102015212477
(43) Veröffentlichungstag der Anmeldung: 09.05.2018
(73) Patentinhaber: OSRAM OLED GmbH, 93055 Regensburg (DE)
(72) Erfinder: ROSENBERGER, Johannes, 93049 Regensburg (DE); RIEDEL, Daniel, 80639 München (DE); WEHLUS, Thomas, 93138 Lappersdorf (DE)
(74) Vertreter: Epping - Hermann - Fischer
(86) Internationale Anmeldenummer: PCT/EP2016/064371
(87) Internationale Veröffentlichungsnummer: WO 2017/005490

(56) Entgegenhaltungen:
- DE-A1-102008 045 948
- JP-A- 2012 190 659
- US-A1- 2013 078 449

## Beschreibung

Die Erfindung betrifft ein organisches lichtemittierendes Bauelement. Ferner betrifft die Erfindung ein Verfahren zur Herstellung eines organischen lichtemittierenden Bauelements.

Leitende Stromaufweitungsstrukturen können beispielsweise auf einer ersten Elektrode eines organischen lichtemittierenden Bauelements, beispielsweise einer organischen Leuchtdiode (OLED), aufgebracht werden, um eine gleichmäßige Abstrahlung des Lichtes oder eine gewünschte Abstrahlung des Lichtes über die Leuchtfläche zu erreichen. Die leitenden Stromaufweitungsstrukturen müssen in der Regel mit einer Isolationsschicht, beispielsweise aus einem organischen nichtleitfähigen Resistmaterial oder einem nichtleitfähigen Oxid oder Nitrid, überzogen werden, damit Ladungsträger nur über die erste Elektrode und nicht über die leitenden Stromaufweitungsstrukturen in den organischen Schichtenstapel injiziert werden. Dies hat jedoch den Nachteil, dass ein zusätzlicher Prozessschritt erfolgen muss, um die Isolationsschicht separat aufzubringen. Ferner können insbesondere bei organischen Isolationsschichten durch den Fertigungsprozess bedingt Zersetzungsprodukte in die für die Abstrahleigenschaften wichtigen Bereiche, beispielsweise des organischen funktionellen Schichtenstapels, eindringen und damit die Lebensdauer der OLED verringern. Ferner kann dadurch eine Leuchtflächeneinengung bewirkt werden. Ferner kann die Höhe im Querschnitt gesehen für die Verkapselung ungünstig sein bei Verwendung einer Isolationsschicht aus beispielsweise einem nichtleitfähigen Resistmaterial.

Eine zu lösende Aufgabe besteht darin, die oben genannten Nachteile zu überwinden. Eine weitere zu lösende Aufgabe besteht darin, ein organisches lichtemittierendes Bauelement bereitzustellen, das schneller, einfacher und/oder kostengünstiger herstellbar ist.

Diese Aufgabe oder diese Aufgaben werden durch ein organisches lichtemittierendes Bauelement gemäß dem unabhängigen Anspruch 1 gelöst. Vorteilhafte Ausgestaltungen und Weiterbildungen der Erfindung sind Gegenstand der abhängigen Ansprüche. Ferner wird diese Aufgabe oder werden diese Aufgaben durch ein Verfahren zur Herstellung eines organischen lichtemittierenden Bauelements gemäß dem unabhängigen Anspruch 14 gelöst. Vorteilhafte Ausgestaltungen und Weiterbildungen des Verfahrens sind Gegenstand der abhängigen Ansprüche 15 und 16.

US 2013/078449 und JP 2012/190659 offenbaren eine Elektrode für eine OLED, wobei Ag-Nanodrähte mit einer Sulfidschicht nicht ganzflächig passiviert sind. In DE 10 2008 045948 wird eine OLED offenbart, wobei Leiterbahnen mit einer Oxidschicht isoliert sind. 11

Erfindungsgemäß weist das organische lichtemittierende Bauelement ein Substrat auf. Über dem Substrat ist eine erste Elektrode angeordnet. Über der ersten Elektrode ist zumindest ein organischer funktioneller Schichtenstapel angeordnet, der zur Emission von Strahlung eingerichtet ist. Auf der ersten Elektrode ist zumindest eine leitende Stromaufweitungsstruktur angeordnet. Insbesondere ist die leitende Stromaufweitungsstruktur dem organischen funktionellen Schichtenstapel zugewandt. Die leitende Stromaufweitungsstruktur weist zumindest ein Metall auf. Die leitende Stromaufweitungsstruktur ist mit einer anorganischen Passivierungsschichtschicht überzogen. Die anorganische Passivierungsschicht umfasst oder besteht aus einem Sulfid, Selenid und/oder Tellurid des zumindest einen Metalls der leitenden Stromaufweitungsstruktur. Insbesondere weist die leitende Stromaufweitungsstruktur zumindest ein Metall oder eine Legierung aus zumindest zwei Metallen auf. Insbesondere besteht dann die anorganische Passivierungsschicht aus einem Sulfid, Selenid und/oder Tellurid der Legierung der leitenden Stromaufweitungsstruktur. Die anorganische Passivierungsschicht ist entweder ein n-Halbleiter oder ein p-Halbleiter, sodass kein Stromfluss, insbesondere kein vertikaler Stromfluss, zwischen der leitenden Stromaufweitungsstruktur und dem organischen funktionellen Schichtenstapel über die anorganische Passivierungsschicht erfolgt. Das organische lichtemittierende Bauelement weist eine zweite Elektrode auf, die über dem organischen funktionellen Schichtenstapel angeordnet ist.

Erfindungsgemäß ist die leitende Stromaufweitungsstruktur elektrisch leitend. Erfindungsgemäß ist die leitende Stromaufweitungsstruktur metallisch.

Alternativ oder zusätzlich kann zumindest eine leitende Stromaufweitungsstruktur zwischen dem Substrat und der ersten Elektrode, also unterhalb der ersten Elektrode angeordnet sein.

Alternativ oder zusätzlich kann das organische lichtemittierende Bauelement zumindest eine leitende Stromaufweitungsstruktur aufweisen, die zumindest zwischen dem einen organischen funktionellen Schichtenstapel und der zweiten Elektrode angeordnet ist. Insbesondere ist die leitende Stromaufweitungsstruktur dem organischen funktionellen Schichtenstapel zugewandt.

Gemäß zumindest einer Ausführungsform ist das organische lichtemittierende Bauelement als eine organische lichtemittierende Diode (OLED) ausgeformt.

Erfindungsgemäß weist das organische lichtemittierende Bauelement ein Substrat auf. Das Substrat kann beispielsweise eines oder mehrere Materialien in Form einer Schicht, einer Platte, einer Folie oder einem Laminat aufweisen, die ausgewählt sind aus Glas, Quarz, Kunststoff, Metall, Siliziumwafer, Keramik, beschichtetes Papier. Besonders bevorzugt weist das Substrat Glas, beispielsweise in Form einer Glasschicht, Glasfolie oder Glasplatte, auf oder ist daraus.

Erfindungsgemäß weist das organische lichtemittierende Bauelement eine erste und zweite Elektrode auf. Insbesondere kann zumindest eine Elektrode transparent ausgebildet sein. Mit transparent wird hier und im Folgenden eine Schicht bezeichnet, die durchlässig für sichtbares Licht ist. Dabei kann die transparente Schicht klar durchscheinend oder zumindest teilweise lichtstreuend und/oder teilweise lichtabsorbierend sein, sodass die transparente Schicht beispielsweise auch diffus oder milchig durchscheinend sein kann. Besonders bevorzugt ist eine hier als transparent bezeichnete Schicht möglichst lichtdurchlässig, sodass insbesondere die Absorption von im Betrieb des organischen lichtemittierenden Bauelements im organischen funktionellen Schichtenstapel erzeugten Lichts so gering wie möglich ist. Alternativ können auch beide Elektroden transparent ausgeformt sein. Damit kann die in dem zumindest einen organischen funktionellen Schichtenstapel erzeugte Strahlung in beide Richtungen, also durch beide Elektroden hindurch, abgestrahlt werden. Für den Fall, dass das organische lichtemittierende Bauelement ein Substrat aufweist, bedeutet das, dass die Strahlung sowohl durch das Substrat hindurch, das dann ebenfalls transparent ausgebildet ist, als auch in die vom Substrat abgewandte Richtung abgestrahlt werden kann. Weiterhin können in diesem Fall alle Schichten des organischen lichtemittierenden Bauelements transparent ausgebildet sein, sodass das organische lichtemittierende Bauelement eine transparente OLED bildet. Darüber hinaus kann es auch möglich sein, dass eine der beiden Elektroden, zwischen denen der organische funktionelle Schichtenstapel angeordnet ist, nicht transparent und vorzugsweise reflektierend ausgebildet ist, sodass die in dem organischen funktionellen Schichtenstapel erzeugte Strahlung nur in eine Richtung durch die transparente Elektrode abgestrahlt werden kann. Ist die auf dem Substrat angeordnete Elektrode transparent, ist auch das Substrat transparent ausgebildet, so spricht man auch von einem sogenannten Bottom-Emitter, während in dem Fall, dass die dem Substrat abgewandt angeordnete Elektrode transparent ausgebildet ist, von einem sogenannten Top-Emitter spricht.

Als Material für eine transparente Elektrode kann beispielsweise ein transparentes, leitfähiges Oxid (TCO Transparent Conductive Oxide), wie zum Beispiel ITO, verwendet werden.

Transparente, elektrisch leitende Oxide (TCO) sind transparente, elektrisch leitende Materialien, in der Regel Metalloxide, wie beispielsweise Zinkoxid, Zinnoxid, Cadmiumoxid, Titanoxid, Indiumoxid, Indiumzinnoxid (ITO) oder Aluminiumzinkoxid (AZO). Neben binären Metallsauerstoffverbindungen wie beispielsweise ZnO, SnO₂ oder In₂O₃ gehören auch ternäre Metallsauerstoffverbindungen wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter, leitender Oxide zu der Gruppe der TCOs. Weiterhin entsprechen die TCOs nicht zwingend einer stöchiometrischen Zusammensetzung und können auch p- oder n-dotiert sein.

Weiterhin kann eine transparente Elektrode auch eine Metallschicht mit einem Metall oder einer Legierung aufweisen, beispielsweise mit einem oder mit mehreren der folgenden Materialien: Silber, Platin, Gold, Magnesium oder eine Legierung aus Silber und Magnesium. Darüber hinaus sind auch andere Metalle möglich. Die Metallschicht weist dabei eine derart geringe Dicke auf, dass sie zumindest teilweise durchlässig für das von dem organischen funktionellen Schichtenstapel erzeugte Licht ist, beispielsweise eine Dicke von kleiner oder gleich 50 nm.

Als Material für eine reflektierende Elektrode kann beispielsweise ein Metall verwendet werden, das ausgewählt sein kann aus Aluminium, Barium, Indium, Silber, Gold, Magnesium, Kalzium und Lithium sowie Verbindungen, Kombinationen und Legierungen daraus. Insbesondere kann eine reflektierende Elektrode Silber, Aluminium oder Legierungen mit diesen aufweisen, beispielsweise Ag:Mg, Ag:Ca, Mg:Al.

Insbesondere können die Elektroden nanostrukturierte Elektroden, beispielsweise Silbernanodrähte oder aus Graphen sein.

Gemäß zumindest einer Ausführungsform ist die erste Elektrode als Anode ausgebildet, dann ist die zweite Elektrode als Kathode ausgebildet. Alternativ kann die erste Elektrode als Kathode ausgebildet sein, dann ist die zweite Elektrode als Anode ausgebildet.

Die Elektroden können auch in Kombination von zumindest einer oder mehreren TCO-Schichten und zumindest eine oder mehrere Metallschichten aufweisen.

Erfindungsgemäß ist zumindest ein organischer funktioneller Schichtenstapel über der ersten Elektrode und/oder dem Substrat angeordnet. Dass eine Schicht oder ein Stapel "auf" oder "über" einer anderen Schicht oder einem Stapel angeordnet oder aufgebracht ist, kann dabei hier und im Folgenden bedeuten, dass die eine Schicht oder der eine Stapel unmittelbar in direktem mechanischem und/oder elektrischem Kontakt auf der anderen Schicht oder dem anderen Stapel angeordnet ist. Weiterhin kann es auch bedeuten, dass die eine Schicht mittelbar auf beziehungsweise über der anderen Schicht oder dem anderen Stapel angeordnet ist. Dabei können dann weitere Schichten oder Stapel zwischen der einen und der anderen Schicht oder Stapel angeordnet sein.

Erfindungsgemäß weist das organische lichtemittierende Bauelement zumindest einen organischen funktionellen Schichtenstapel auf. Insbesondere weist das organische lichtemittierende Bauelement genau einen organischen funktionellen Schichtenstapel auf. Im Betrieb des organischen lichtemittierenden Bauelements wird in dem organischen funktionellen Schichtenstapel Strahlung erzeugt. Eine Wellenlänge der Strahlung oder das Wellenlängenmaximum liegt bevorzugt im infraroten und/oder ultravioletten und/oder sichtbaren Spektralbereich, insbesondere bei Wellenlängen zwischen einschließlich 420 nm und 680 nm.

Der organische funktionelle Schichtenstapel kann Schichten mit organischen Polymeren, organischen Oligomeren, organischen Monomeren, organischen kleinen nichtpolymeren Molekülen ("small molecules") oder Kombinationen daraus aufweisen. Der organische funktionelle Schichtenstapel kann zusätzlich weitere funktionelle Schichten aufweisen, die als Lochtransportschicht ausgeführt sind, um eine effektive Löcherinjektion in den zumindest einen organischen funktionellen Schichtenstapel zu ermöglichen. Als Materialien für eine Lochtransportschicht können sich beispielsweise tertiäre Amine, Carbazolderivate, mit Kampfersulfonsäure dotiertes Polyanilin oder mit Polystyrolsulfonsäure dotiertes Polyethylendioxidthiophen als vorteilhaft erweisen. Der organische funktionelle Schichtenstapel kann weiterhin zumindest eine funktionelle Schicht aufweisen, die als Elektronentransportschicht ausgebildet ist. Allgemein kann der organische funktionelle Schichtenstapel zusätzliche Schichten aufweisen, die ausgewählt sind aus Löcherinjektionsschichten, Lochtransportschichten, Elektroninjektionsschichten, Elektrontransportschichten, Lochblockierschichten und Elektronenblockierschichten. Insbesondere können die Schichten des organischen funktionellen Schichtenstapels vollständig oder zumindest überwiegend organische funktionelle Schichten sein. Darüber hinaus kann es auch möglich sein, dass einzelne Schichten des organischen funktionellen Schichtenstapels auch anorganische Materialien aufweisen oder daraus gebildet sind.

Erfindungsgemäß weist das organische lichtemittierende Bauelement zumindest eine leitende Stromaufweitungsstruktur auf. Die leitende Stromaufweitungsstruktur ist auf der ersten Elektrode angeordnet. Insbesondere ist die leitende Stromaufweitungsstruktur in direktem elektrischem und/oder mechanischem Kontakt auf der ersten Elektrode angeordnet. Die leitende Stromaufweitungsstruktur ist insbesondere dem organischen funktionellen Schichtenstapel zugewandt. Mit anderen Worten ragt die leitende Stromaufweitungsstruktur zumindest teilweise oder vollständig in den organischen funktionellen Schichtenstapel hinein. Die nur zumindest teilweise in den organischen funktionellen Schichtenstapel hineinragenden leitenden Stromaufweitungsstrukturen, auch äußere leitende Stromaufweitungsstrukturen genannt, können zur direkten Kontaktierung mit der zweiten Elektrode dienen. Insbesondere können mehrere leitende Stromaufweitungsstrukturen, beispielsweise acht bis 50, in einem organischen lichtemittierenden Bauelement vorhanden sein.

Erfindungsgemäß weist die leitende Stromaufweitungsstruktur zumindest ein Metall auf. Insbesondere kann das Metall mit zumindest einem weiteren Metall eine Legierung bilden. Legierung kann auch bedeuten, dass das zumindest eine Metall mit weiteren Metallen ein Mischkristall bildet, beispielsweise CuInS₂. Insbesondere können jegliche Metalle für die leitende Stromaufweitungsstruktur verwendet werden. Die daraus resultierenden anorganischen Passivierungsschichten, beispielsweise die Sulfide, Selenide und/oder Telluride, sollten dabei die Eigenschaft aufweisen, dass sie als n-Halbleiter oder p-Halbleiter verwendet werden können. Dies kann beispielsweise auch durch Dotierung während der Herstellung erzeugt werden. Insbesondere ist das Metall oder die Legierung der leitenden Stromaufweitungsstruktur aus einer Gruppe ausgewählt, die Silber, Aluminium, Molybdän, Chrom, Kupfer, Magnesium oder eine Legierung aus Molybdän-Aluminium (Mo:Al), Chrom-Aluminium (Cr:Al), Silber-Magnesium (Ag:Mg) und Kombinationen daraus umfassen. Besonders bevorzugt ist die leitende Stromaufweitungsstruktur aus Silber geformt.

Die leitende Stromaufweitungsstruktur kann auch ein leitfähiges Glas, eine leitfähige Keramik oder ein hochdotierter Halbleiter sein. Insbesondere ist das der Fall, wenn die leitende Stromaufweitungsstruktur mit einer Metallschicht, vorzugsweise mit Silber, überzogen ist.

Gemäß zumindest einer Ausführungsform besteht die leitende Stromaufweitungsstruktur aus einem Metall, insbesondere aus Silber. Alternativ kann die leitende Stromaufweitungsstruktur einen Schichtaufbau aufweisen. Beispielsweise kann die Stromaufweitungsstruktur drei Schichten aus zwei oder drei unterschiedlichen Metallen aufweisen. Insbesondere weist die leitende Stromaufweitungsstruktur eine Schichtstruktur auf, die zumindest zwei Silberschichten umfasst, wobei die zwei Silberschichten durch eine weitere Metallschicht voneinander getrennt sind. Insbesondere ist die weitere Metallschicht aus einem Metall geformt.

Die leitenden Stromaufweitungsstrukturen können jede beliebige Form aufweisen. Insbesondere können die leitenden Stromaufweitungsstrukturen in Draufsicht auf das organische lichtemittierende Bauelement parallel zueinander verlaufende Zuleitungsstrukturen sein. Die parallel verlaufenden Zuleitungsstrukturen können einen gleichen Abstand oder einen unterschiedlichen Abstand zueinander aufweisen. Im Falle, dass die Zuleitungsstrukturen einen gleichen Abstand zueinander aufweisen, kann eine gleichmäßige Abstrahlung der Strahlung oder eine gewünschte Abstrahlung der Strahlung über die Leuchtfläche erzeugt werden.

Alternativ oder zusätzlich kann die leitende Stromaufweitungsstruktur in Form eines Rechtecks oder in wabenförmiger Form ausgestaltet sein.

Gemäß zumindest einer Ausführungsform ist die leitende Stromaufweitungsstruktur direkt auf der ersten Elektrode, welche insbesondere transparent ausgeformt ist, aufgebracht. Das Aufbringen kann beispielsweise mittels Sputtern oder physikalischer Gasphasenabscheidung (physical vapor deposition, kurz PVD) erfolgen.

Erfindungsgemäß ist die leitende Stromaufweitungsstruktur mit einer anorganischen Passivierungsschicht überzogen. Die leitende Stromaufweitungsstruktur weist eine Oberfläche, die dem Substrat abgewandt ist, und Seitenflächen auf. Erfindungsgemäß sind sowohl die Oberfläche als auch die Seitenflächen mit der anorganischen Passivierungsschicht überzogen. "Überzogen" meint hier und im Folgenden, dass die anorganische Passivierungsschicht ganzflächig die Seitenflächen und die Oberfläche der leitenden Stromaufweitungsstruktur umhüllt oder bedeckt. Insbesondere umhüllt die anorganische Passivierungsschicht die Oberfläche und Seitenfläche der leitenden Stromaufweitungsstruktur formschlüssig.

Gemäß zumindest einer Ausführungsform bedeckt die anorganische Passivierungsschicht die dem Substrat abgewandte Oberfläche und Seitenflächen der leitenden Stromaufweitungsstruktur direkt. Mit "direkt" ist hier und im Folgenden gemeint, dass die anorganische Passivierungsschicht in direktem mechanischem Kontakt auf der Oberfläche als auch auf den Seitenflächen der leitenden Stromaufweitungsstruktur angeordnet ist. Es sind also keine weiteren Schichten oder Elemente zwischen der Oberfläche und/oder Seitenflächen der leitenden Stromaufweitungsstruktur und der anorganischen Passivierungsschicht angeordnet.

Erfindungsgemäß umfasst die anorganische Passivierungsschicht ein Sulfid und/oder Selenid und/oder Tellurid des zumindest einen Metalls oder der Legierung der leitenden Stromaufweitungsstruktur oder besteht daraus. Insbesondere ist die anorganische Passivierungsschicht frei von organischen Resistmaterialien, Metalloxiden, Nitriden und/oder Siliziumoxid.

Erfindungsgemäß ist die anorganische Passivierungsschicht ein n-Halbleiter. Alternativ ist die anorganische Passivierungsschicht ein p-Halbleiter.

Mit n-Halbleiter wird hier und im Folgenden bezeichnet, dass die anorganische Passivierungsschicht dazu befähigt ist, Elektronen zu leiten und die Leitung von Löchern unterbindet. Mit anderen Worten wirkt die als n-Halbleiter ausgeformte anorganische Passivierungsschicht als lochisolierende Schicht. Damit wird die Löcherinjektion von der leitenden Stromaufweitungsstruktur in die angrenzenden Lochtransportschichten und/oder Lochinjektionsschichten und/oder den organischen funktionellen Schichtenstapel unterbunden.

Mit p-Halbleiter wird hier und im Folgenden bezeichnet, dass die anorganische Passivierungsschicht die Löcher leitet und die Leitung von Elektronen unterbindet. Die als n- oder p-Halbleiter ausgeformte anorganische Passivierungsschicht ermöglicht keinen Stromfluss, insbesondere keinen direkten und/oder vertikalen Stromfluss, zwischen der leitenden Stromaufweitungsstruktur und dem organischen funktionellen Schichtenstapel über die anorganische Passivierungsschicht.

Im Fall, dass die anorganische Passivierungsschicht als n-Halbleiter ausgeformt ist, bedeutet das, dass ein Löchertransport von der als Anode ausgeformten ersten Elektrode über die anorganische Passivierungsschicht in Richtung organischen funktionellen Schichtenstapel unterbunden ist. Im Fall einer als p-Halbleiter ausgeformten anorganischen Passivierungsschicht bedeutet das, dass ein Elektronentransport von der als Kathode ausgeformten ersten Elektrode über die anorganische Passivierungsschicht in Richtung organischen funktionellen Schichtenstapel unterbunden ist.

Gemäß zumindest einer Ausführungsform ist die anorganische Passivierungsschicht durch Sulfidisierung des zumindest einen Metalls der leitenden Stromaufweitungsstruktur erzeugt. Mit anderen Worten wird hier das Metall oder die Legierung der leitenden Stromaufweitungsstruktur mit einer schwefelionenhaltigen Atmosphäre, einer schwefelionenhaltigen Lösung und/oder einem schwefelionenhaltigen Plasma behandelt, sodass aus dem Metall der leitenden Stromaufweitungsstruktur eine anorganische Passivierungsschicht erzeugt ist, die ein Sulfid umfasst oder daraus besteht.

Gemäß zumindest einer Ausführungsform ist die erste Elektrode als Anode ausgeformt. Insbesondere ist die Anode transparent. Die anorganische Passivierungsschicht ist ein n-Halbleiter, sodass ein Löchertransport von der ersten Elektrode über die anorganische Passivierungsschicht in Richtung organischen funktionellen Schichtenstapel unterbunden ist. Mit anderen Worten wirkt die anorganische Passivierungsschicht für die von der Anode emittierten Löcher isolierend. Die anorganische Passivierungsschicht ist für Elektronen durchlässig.

Gemäß zumindest einer Ausführungsform weist die leitende Stromaufweitungsstruktur ein Metall, vorzugsweise Silber, auf. Die anorganische Passivierungsschicht umfasst ein Metallsulfid, vorzugsweise Silbersulfid, oder besteht daraus. Insbesondere wird die anorganische Passivierungsschicht durch Sulfidisierung des Metalls, vorzugsweise Silbers, der leitenden Stromaufweitungsstruktur erzeugt. Das Erzeugen kann beispielsweise mittels einer Schwefelwasserstoffatmosphäre erfolgen. Insbesondere wird das Metall, vorzugsweise Silber, der leitenden Stromaufweitungsstruktur nur oberflächlich sulfidisiert. Dadurch wird ein n-Halbleiter, vorzugsweise Silbersulfid (Ag₂S), erzeugt, der nichtlöcherleitende Eigenschaften aufweist. Silbersulfid ist eine chemische Verbindung aus der Gruppe der Sulfide, die aus einer chemischen Reaktion von Schwefel und Silber entsteht.

Gemäß zumindest einer Ausführungsform ist das organische lichtemittierende Bauelement dazu eingerichtet, die von dem organischen funktionellen Schichtenstapel erzeugte Strahlung über die erste Elektrode und das Substrat zu emittieren. Mit anderen Worten ist das organische lichtemittierende Bauelement als Bottom-Emitter ausgeformt.

Gemäß zumindest einer Ausführungsform weist die leitende Stromaufweitungsstruktur ein Metall, vorzugsweise Silber, auf oder besteht daraus. Die anorganische Passivierungsschicht ist durch Telluridisierung zumindest des Metalls, vorzugsweise Silbers, der leitenden Stromaufweitungsstruktur erzeugt. Mit anderen Worten wird aus dem Metall, vorzugsweise Silber, der leitenden Stromaufweitungsstruktur eine anorganische Passivierungsschicht erzeugt, die ein Metalltellurid, vorzugsweise Silbertellurid (Ag₂Te) umfasst oder daraus besteht. Silbertellurid ist eine monokline Kristallverbindung aus der Gruppe der Telluride, die aus Silber und Tellur im Hochtemperaturprozess gebildet wird. Silbertellurid ist insbesondere ein n-Halbleiter. Vorzugsweise ist dann in dem Fall die erste Elektrode als Anode ausgeformt.

Gemäß zumindest einer Ausführungsform ist die anorganische Passivierungsschicht durch Selenidisierung zumindest des Metalls der leitenden Stromaufweitungsstruktur erzeugt. Die anorganische Passivierungsschicht weist dann zumindest ein Selenid auf oder besteht daraus.

Die Erfinder haben erkannt, dass durch die Verwendung einer anorganischen Passivierungsschicht, welche entweder ein n- oder p-Halbleiter ist und ein Sulfid, Selenid und/oder Tellurid des zumindest einen Metalls der leitenden Stromaufweitungsstruktur umfasst, keine Rückstrukturierung erfolgen muss. Ferner ist das Aufbringen der anorganischen Passivierungsschicht in einem einfachen reaktiven Prozessschritt möglich. Insbesondere wird die anorganische Passivierungsschicht aus einem Silbersulfid, Silberselenid und/oder Silbertellurid, vorzugsweise einem Silbersulfid, gebildet. Alternativ kann Silbersulfid, Silberselenid und/oder Silbertellurid zusätzlich n-dotiert sein. Silber ist das Material mit der höchsten bekannten elektrischen Leitfähigkeit. Dadurch kann bei gleicher Schichtdicke wie bei den bisher üblichen leitenden Stromaufweitungsstrukturen, die beispielsweise einen Schichtaufbau aus Chrom, Aluminium und Chrom aufweisen, eine höhere Leitfähigkeit erzielt werden beziehungsweise die Schichtdicke kann reduziert werden, um die gleiche Leitfähigkeit des bisherigen Schichtenstapels zu erreichen.

Gemäß zumindest einer Ausführungsform ist die erste oder die zweite Elektrode als Kathode ausgeformt. Die anorganische Passivierungsschicht ist ein p-Halbleiter, sodass ein Elektronentransport von der ersten Elektrode oder der zweiten Elektrode über die anorganische Passivierungsschicht in Richtung organischen funktionellen Schichtenstapel unterbunden ist. Mit anderen Worten ist die erste oder zweite Elektrode als Kathode ausgeformt und dazu eingerichtet, Elektronen in Richtung organischen funktionellen Schichtenstapel zu emittieren. Da die anorganische Passivierungsschicht als p-Halbleiter ausgebildet ist und daher nur durchlässig für Löcher ist, wirkt die anorganische Passivierungsschicht in dem Fall als elektronenisolierende Schicht. Damit werden keine Elektronen über die anorganische Passivierungsschicht in den organischen funktionellen Schichtenstapel transportiert.

Gemäß zumindest einer Ausführungsform ist die zweite Elektrode als Kathode ausgeformt. Insbesondere ist das organische lichtemittierende Bauelement als transparente OLED ausgeformt. Dies bedeutet, dass die von dem organischen funktionellen Schichtenstapel erzeugte Strahlung sowohl über die erste Elektrode als auch über die zweite Elektrode emittiert. Die zweite Elektrode weist insbesondere dann eine anorganische Passivierungsschicht auf, die ein p-Halbleiter ist. Zusätzlich weist insbesondere die erste Elektrode eine anorganische Passivierungsschicht auf, die als n-Halbleiter ausgebildet ist. Damit wirken die jeweiligen Passivierungsschichten als Loch- oder Elektronenisolator. Damit wird ein direkter Stromfluss durch die jeweiligen Passivierungsschichten unterbunden.

Gemäß zumindest einer Ausführungsform ist die anorganische Passivierungsschicht eine Mischung von zumindest zwei unterschiedlichen Metallsulfiden. Insbesondere ist jedes Metallsulfid der Mischung ein n- oder p-Halbleiter.

Gemäß zumindest einer Ausführungsform weist die anorganische Passivierungsschicht eine Schichtdicke zwischen einschließlich 10 nm und 100 nm, insbesondere von 5 nm bis 50 nm auf. Insbesondere weist die anorganische Passivierungsschicht eine Schichtdicke von kleiner oder gleich 10 nm auf. Insbesondere ist die Schichtdicke so dick, dass der Tunnelstrom vermieden wird. Dadurch kann der Tunnelstrom unterbunden werden und zugleich sind die leitenden Stromaufweitungsstrukturen quasi unsichtbar, da die anorganische Passivierungsschicht sehr dünn ausgeformt ist.

Gemäß zumindest einer Ausführungsform ist die anorganische Passvierungsschicht zusätzlich oder alternativ auf der ersten Elektrode und/oder der leitenden Stromaufweitungsstruktur, die zumindest außerhalb des organisch funktionellen Schichtenstapels angeordnet ist, aufgebracht.

Durch die Verwendung einer anorganischen Passivierungsschicht auf leitenden Stromaufweitungsstrukturen sind diese quasi unsichtbar, verglichen mit Polyimid beschichteten leitenden Stromaufweitungsstrukturen, da die anorganische Passivierungsschicht sehr dünn ausgeformt wird. Ferner weisen diese eine sichere Isolierung gegenüber Löcher oder Elektronen auf. Die anorganische Passivierungsschicht ist zudem einfach und billig herstellbar und ist sehr gut in seinen Eigenschaften kontrollierbar. Die Herstellung einer anorganischen Passivierungsschicht ist leicht in bestehende Prozesse integrierbar, beispielsweise auch dann, wenn ein Ausheizen der Substrate nach der Reinigung notwendig ist. Gleichzeitig wird auch die Eigenschaft der ersten Elektrode, insbesondere aus TCO, beeinflusst, da eine niedrigere Spannung in dem organischen lichtemittierenden Bauelement nötig ist, was zu einer höheren Lebensdauer führt.

Da die mit einer anorganischen Passivierungsschicht überzogenen leitenden Stromaufweitungsstrukturen quasi unsichtbar sind, können diese beliebig angeordnet werden, um zum Beispiel eine beabsichtigte Inhomogenität zu erzeugen. Die leitenden Stromaufweitungsstrukturen weisen insbesondere eine Breite von 50 µm auf. Ein breiterer Resist ist nicht notwendig.

Die mit einer anorganischen Passivierungsschicht überzogenen leitenden Stromaufweitungsstrukturen können aufgrund ihrer geringen Größe sehr dicht aneinander angeordnet werden. Dies trägt dazu bei, dass ab einem gewissen Abstand die leitenden Stromaufweitungsstrukturen nicht mehr wahrnehmbar sind, also eine Verschmierung zwischen einer leuchtenden Fläche und nichtleuchtenden leitenden Stromaufweitungsstruktur erzeugt wird. Insbesondere können leitende Stromaufweitungsstrukturen eine Breite von 1 µm, insbesondere bis minimal oder maximal 1 µm, einnehmen.

Zudem stellen mit einer anorganischen Passivierungsschicht überzogene leitende Stromaufweitungsstrukturen eine sichere Isolierung verglichen mit durch Siebdruck beschichteten Stromaufweitungsstrukturen dar.

Gemäß zumindest einer Ausführungsform weist die leitende Stromaufweitungsstruktur eine dem Substrat abgewandte Oberfläche und Seitenflächen auf, wobei die anorganische Passivierungsschicht sowohl die Oberfläche als auch die Seitenflächen direkt bedeckt.

Gemäß zumindest einer Ausführungsform weist die leitende Stromaufweitungsstruktur eine Metallschicht auf oder umfasst diese. Die leitende Stromaufweitungsstruktur weist eine dem Substrat abgewandte Oberfläche und Seitenflächen auf. Die Metallschicht bedeckt, insbesondere direkt, die dem Substrat abgewandte Oberfläche und Seitenflächen der leitenden Stromaufweitungsstruktur. "Direkt" bedeutet hier, in direktem mechanischem Kontakt. Die anorganische Passivierungsschicht kann aus der Metallschicht erzeugt sein. Insbesondere wird die anorganische Passivierungsschicht durch Sulfidisierung, Telluridisierung und/oder Selenidisierung der Metallschicht erzeugt und ist zumindest an der Oberfläche und an den Seitenflächen der leitenden Stromaufweitungsstruktur angeordnet oder bedeckt diese.

Mit anderen Worten wird hier eine Metallschicht auf die leitende Stromaufweitungsstruktur aufgebracht, wobei die Dicke der Metallschicht beliebig einstellbar ist. Die Metallschicht umformt dabei sowohl die Seitenflächen als auch die Oberfläche der leitenden Stromaufweitungsstruktur. Anschließend kann die Metallschicht dann zumindest teilweise sulfidisiert, telluridisiert und/oder selenidisiert werden, wobei die Metallschicht sich zumindest teilweise in eine anorganische Passivierungsschicht umwandelt. Damit kann eine einheitliche anorganische Passivierungsschicht aus einem einheitlichen Material erzeugt werden.

Gemäß zumindest einer Ausführungsform weist die anorganische Passivierungsschicht eine Dicke von kleiner oder gleich 10 nm auf. Im Vergleich zur herkömmlichen Isolationsschicht ist die anorganische Passivierungsschicht bei einer derartigen Dicke dicht.

Gemäß zumindest einer Ausführungsform weist die Metallschicht Silber auf oder besteht daraus. Die anorganische Passivierungsschicht weist dann Silbersulfid auf oder besteht daraus.

Gemäß zumindest einer Ausführungsform weist das organische lichtemittierende Bauelement eine Verkapselung auf. Die Verkapselung ist bevorzugt in Form einer Dünnschichtverkapselung auf dem organischen lichtemittierenden Bauelement aufgebracht. Insbesondere schützt die Verkapselung den zumindest einen organischen funktionellen Schichtenstapel und die Elektroden vor der Umgebung wie beispielsweise vor Feuchtigkeit und/oder Sauerstoff und/oder anderen korrosiven Substanzen. Die Verkapselung kann ein oder mehrere dünne Schichten aufweisen, die beispielsweise mittels eines Atomlagenabscheideverfahrens aufgebracht sind und die beispielsweise eines oder mehrere der Materialien Aluminiumoxid, Zinkoxid, Zirkoniumoxid, Titanoxid, Hafniumoxid, Lanthanoxid und Tantaloxid aufweisen. Die Verkapselung kann weiterhin beispielsweise auf einer Dünnschichtverkapselung einen mechanischen Schutz in Form einer Kunststoffschicht und/oder einer auflaminierten Glasschicht aufweisen, wodurch beispielsweise ein Kratzschutz erreicht werden kann.

Alternativ kann auch eine andere Verkapselung möglich sein, beispielsweise in Form eines aufgeklebten Glasdeckels. Insbesondere ist der Glasdeckel oder das Glas mittels eines Klebers oder einer Klebeschicht auf der Dünnschichtverkapselung angeordnet. Alternativ kann statt einer Dünnfilmbeschichtung (TFE) eine Cavity-Verkapselung mit Gettermaterial verwendet werden.

Die Dünnfilmverkapselung kann z.B. folgendermaßen aufgebaut sein: eine Mischung aus Siliziumnitrid, aus Siliziumoxid beliebiger Oxidationsstufe und Siliziumcarbid in beliebiger Zusammensetzung und Reihenfolge. Alternativ oder zusätzlich kann eine Verkapselung aus einem Aluminiumoxid beliebiger Oxidationsstufe und einem Titanoxid beliebiger Oxidationsstufe in beliebiger Dicke und Reihenfolge verwendet werden.

Gemäß zumindest einer Ausführungsform weist die Verkapselung eine Schichtdicke von 20 bis 5000 nm auf. Speziell für eine Verkapselung aus Siliziumnitrid, Siliziumoxid und Siliziumcarbid weist insbesondere die Verkapselung eine Schichtdicke von 0,5 bis 5 µm, beispielsweise 1 nm bis 3 µm, auf. Für eine Verkapselung aus Aluminiumoxid und Titanoxid kann eine Schichtdicke von 40 bis 60 nm, beispielsweise 50 nm, verwendet werden.

Die Erfindung betrifft ferner ein Verfahren zur Herstellung eines organischen lichtemittierenden Bauelements. Vorzugsweise wird mit dem Verfahren ein organisches lichtemittierendes Bauelement hergestellt. Dabei gelten die gleichen Definitionen und Ausführungen wie vorstehend für das organische lichtemittierende Bauelement auch für das Verfahren und umgekehrt.

Erfindungsgemäß weist das Verfahren zur Herstellung eines organischen lichtemittierenden Bauelements die Verfahrensschritte auf:
A) Bereitstellen eines Substrats,
B) Aufbringen einer ersten Elektrode auf das Substrat,
C) Aufbringen zumindest einer leitenden Stromaufweitungsstruktur auf die erste Elektrode. Die leitende Stromaufweitungsstruktur weist zumindest ein Metall und eine dem Substrat abgewandte Oberfläche und Seitenflächen auf.
D) Selektive Ausbildung einer anorganischen Passivierungsschicht zumindest auf der Oberfläche und den Seitenflächen der leitenden Stromaufweitungsstruktur, wobei die anorganische Passivierungsschicht ein Sulfid, Selenid und/oder Tellurid des zumindest einen Metalls der leitenden Stromaufweitungsstruktur umfasst oder daraus besteht. Die anorganische Passivierungsschicht ist entweder ein n- oder ein p-Halbleiter, sodass kein Stromfluss zwischen der leitenden Stromaufweitungsstruktur und dem organischen funktionellen Schichtenstapel über die anorganische Passivierungsschicht erfolgt.
E) Aufbringen eines organischen funktionellen Schichtenstapels zumindest auf die anorganische Passivierungsschicht und zumindest teilweise auf die erste Elektrode,
F) Aufbringen einer zweiten Elektrode.

Gemäß zumindest einer Ausführungsform erfolgt vor Schritt D) ein zusätzlicher Schritt C1):
C1) Selektives Aufbringen einer Schutzschicht auf Bereiche der ersten Elektrode, die frei von der leitenden Stromaufweitungsstruktur sind und wobei nach Schritt D) ein zusätzlicher Schritt D1) erfolgt:
D1) Entfernen der Schutzschicht.

Die Schutzschicht bewirkt, dass die erste Elektrode durch den Schritt D) geschützt wird, also insbesondere nicht sulfidisiert, telluridisiert oder selenidisiert wird. Die Schutzschicht kann durch selektives Ätzen, Ablation und/oder Lift-Off-Verfahren wieder entfernt werden.

Gemäß zumindest einer Ausführungsform wird die Sulfidisierung im Schritt D) mittels einer Schwefelwasserstoff umfassenden Atmosphäre durchgeführt. Die Schwefelwasserstoff umfassende Atmosphäre kann beispielsweise durch Schwefelwasserstofflösung erzeugt werden. Insbesondere weist die Schwefelwasserstofflösung mindestens 99 % Schwefelwasserstoff auf. Die Schwefelwasserstoff umfassende Atmosphäre kann beispielsweise in einer Exsikkatorglocke erzeugt werden. Alternativ kann die Schwefelwasserstoff umfassende Atmosphäre auch in einer Prozesskammer erzeugt werden. Insbesondere sollte die Prozesskammer von der Umwelt abgeschlossen sein, um gesundheitliche Schäden durch Schwefelwasserstoff zu vermeiden.

Alternativ kann die Sulfidisierung im Schritt D) mittels einer schwefelhaltigen Lösung, insbesondere einer schwefelionenhaltigen Lösung, erfolgen. Insbesondere erfolgt dann der Schritt D) durch Tauchen. Dabei kann jegliche schwefelionenhaltige Lösung, wie beispielsweise Ammoniumsulfid ((NH₄)₂S) verwendet werden.

Alternativ oder zusätzlich kann die leitende Stromaufweitungsstruktur, die insbesondere aus Silber besteht, mittels eines schwefelhaltigem Plasmas, insbesondere eines schwefelionenhaltigem Plasmas, zur Sulfidisierung behandelt werden. Das schwefelionenhaltige Plasma basiert insbesondere auf gasförmigem Schwefelwasserstoff.

Gemäß zumindest einer Ausführungsform erfolgt die Telluridisierung mittels einer tellurhaltigen Atmosphäre, Lösung und/oder Plasma.

Gemäß zumindest einer Ausführungsform erfolgt die Selenidisierung mittels einer selenhaltigen Atmosphäre, Lösung und/oder Plasma.

Gemäß zumindest einer Ausführungsform erfolgt Schritt C) strukturiert. Insbesondere erfolgt Schritt C) mittels Druckverfahren, wie beispielsweise Inkjetverfahren oder Gravurdrucken, oder Aufdampfen.

Gemäß zumindest einer Ausführungsform wird die leitende Stromaufweitungsstruktur im Schritt C) durch ganzflächiges Aufbringen zumindest eines Metalls oder einer Legierung auf die erste Elektrode und anschließendem selektiven Entfernen des Metalls oder der Legierung geformt. Mit anderen Worten wird das Metall oder die Legierung der leitenden Stromaufweitungsstruktur ganzflächig auf das Substrat unstrukturiert aufgebracht. Anschließend erfolgt die Erzeugung der leitenden Stromaufweitungsstruktur beispielsweise durch Ätzprozesse.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Figuren 1A und B: eine schematische Darstellung eines organischen lichtemittierenden Bauelements gemäß eines Vergleichsbeispiels,
- Figur 1C: eine schematische Seitenansicht eines organischen lichtemittierenden Bauelements gemäß einer Ausführungsform,
- Figur 2: eine schematische Draufsicht eines organischen lichtemittierenden Bauelements gemäß einer Ausführungsform,
- Figuren 3A und 3B: jeweils eine schematische Seitenansicht eines Ausschnittes eines organischen lichtemittierenden Bauelements gemäß einer Ausführungsform,
- Figuren 4A und 4B: jeweils eine schematische Seitenansicht eines Ausschnittes eines organischen lichtemittierenden Bauelements gemäß einer Ausführungsform,
- Figuren 5A bis 5F: ein Verfahren zur Herstellung eines organischen lichtemittierenden Bauelements gemäß einer Ausführungsform,
- Figuren 6A bis 6D: ein Verfahren zur Herstellung eines organischen lichtemittierenden Bauelements gemäß einer Ausführungsform,
- Figuren 7A bis 7D: ein Verfahren zur Herstellung eines organischen lichtemittierenden Bauelements gemäß einer Ausführungsform und
- Figuren 8A bis 8E: ein Verfahren zur Herstellung eines organischen lichtemittierenden Bauelements gemäß einer Ausführungsform.

In den Ausführungsbeispielen und Figuren können gleiche, gleich wirkende oder gleichartige Elemente jeweils mit denselben Bezugszeichen versehen sein. Die dargestellten Elemente und deren Größenverhältnisse untereinander sind nicht als maßstabsgerecht anzusehen. Vielmehr können einzelne Elemente wie zum Beispiel Schichten, Bauteile, Bauelemente und Bereiche zur besseren Darstellbarkeit und/oder zum besseren Verständnis übertrieben groß dargestellt sein.

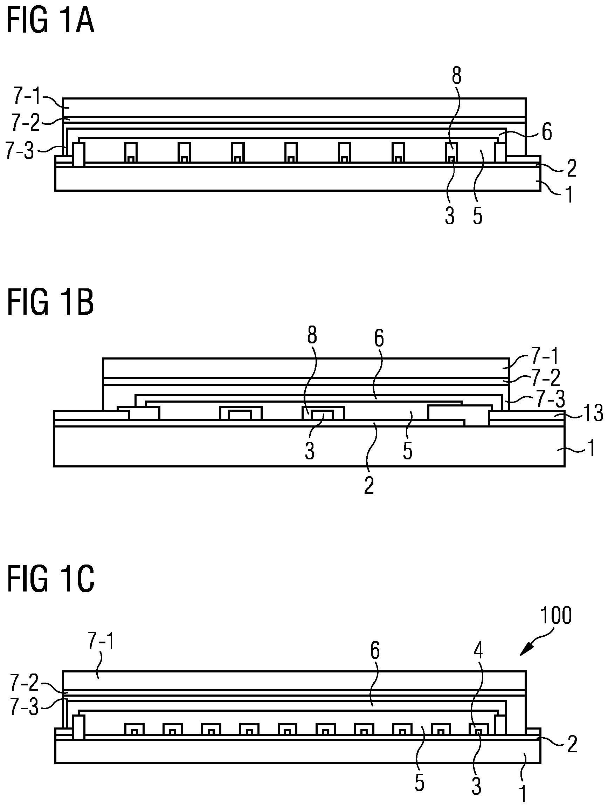

Die Figuren 1A und 1B zeigen jeweils eine schematische Seitenansicht eines organischen lichtemittierenden Bauelements gemäß eines Vergleichsbeispiels. Die Bauelemente weisen jeweils ein Substrat 1, eine erste Elektrode 2, leitende Stromaufweitungsstrukturen 3, eine zweite Elektrode 6 und einen organischen funktionellen Schichtenstapel 5 auf. Die Elektroden 2, 6 können transparent oder nicht transparent ausgeformt sein. Die Elektroden 2, 6 können insbesondere jeweils aus ITO, dünnen Metallschichten, leitenden Netzstrukturen, Graphen oder Kombinationen daraus geformt sein. Zumindest der organische funktionelle Schichtenstapel 5 ist mittels einer Verkapselung 7 von Umwelteinflüssen geschützt. Die Verkapselung 7 umfasst eine Dünnfilmbeschichtung (TFE)7-3, eine Kleberschicht 7-2 und ein Glas 7-1. Statt des Glases 7-1 kann auch ein Substrat 1, ein Schutzglas oder andere Schutzschichten verwendet werden. Für die Dünnfilmbeschichtung (TFE) 7-3 kann alternativ eine Cavity-Verkapselung verwendet werden. Das Bauelement der Figur 1B weist eine weitere Kontaktschicht 13 auf. Die weitere Kontaktschicht 13 kann auch fehlen, so dass auch eine direkte Kontaktierung auf der ersten Elektrode 2 erfolgen kann. Die leitenden Stromaufweitungsstrukturen 3 sind durch eine organische Isolatorschicht 8 gegen den im Anschluss aufgedampften organischen funktionellen Schichtenstapel 5 geschützt. Die organische Isolationsschicht 8 ist insbesondere Polyimid und kann beispielsweise mittels Maskenprozesse aufgebracht werden. Die organische Isolationsschicht 8 weist eine hohe Resisthöhe von insbesondere 1 µm bis 7 µm auf, ragt also sehr weit in den organischen funktionellen Schichtenstapel 5 hinein. Dadurch sind die leitenden Stromaufweitungsstrukturen 3 in Draufsicht auf das Bauelement 100 sichtbar. Ferner können durch den starken Höhenunterschied an den leitenden Stromaufweitungsstrukturen 3 bei der Abscheidung des organischen funktionellen Schichtenstapels 5 und/oder der Verkapselung 5 ein Kurzschluss und/oder Undichtigkeiten entstehen. Die organische Isolationsschicht 8, die insbesondere organische Verbindungen umfasst, kann während des Fertigungsprozesses ausdampfen, so dass Zersetzungsprodukte der organischen Verbindung der organischen Isolationsschicht 8 in den organischen funktionellen Schichtenstapel 5 gelangen können. Damit kann die Lebensdauer des organischen lichtemittierenden Bauelements 100 verringert werden.

Figur 1C zeigt eine schematische Seitenansicht eines organischen lichtemittierenden Bauelements 100 gemäß einer Ausführungsform. Die Figur 1C unterscheidet sich im Vergleich zu den Vergleichsbeispielen der Figuren 1A und 1B dadurch, dass statt einer organischen Isolationsschicht 8 hier eine anorganische Passivierungsschicht 4 verwendet wird. Insbesondere ist die erste Elektrode 2 als Anode ausgeformt und die anorganische Passivierungsschicht 4 ein n-Halbleiter, so dass ein Löchertransport von der ersten Elektrode 2 über die anorganische Passivierungsschicht 4 in Richtung organischen funktionellen Schichtenstapel 5 unterbunden ist. Die anorganische Passivierungsschicht 4 dient also für die leitenden Stromaufweitungsstrukturen 3 der Anode zur Löcherisolierung. Die anorganische Passivierungsschicht 4 weist insbesondere eine Schichtdicke von ≤ 10 nm auf. Insbesondere überformt die anorganische Passivierungsschicht 4 sowohl die Seitenflächen 3-2 als auch die Oberfläche 3-1 der jeweiligen leitenden Stromaufweitungsstruktur 3. Mit Oberfläche 3-1 ist hier die Oberfläche gemeint, die dem Substrat 1 abgewandt ist. Die anorganische Passivierungsschicht 4 ist insbesondere ein Sulfid, Selenid und/oder Tellurid des zumindest einen Metalls der leitenden Stromaufweitungsstruktur 3. Insbesondere erfolgt die Sulfidbildung durch eine Schwefelwasserstoff umfassende Atmosphäre, eine schwefelionenhaltige oder schwefelhaltige Lösung oder ein schwefelionenhaltiges oder schwefelhaltiges Plasma.

Weist vorzugsweise die leitende Stromaufweitungsstruktur 3 Silber auf, so wird die anorganische Passivierungsschicht 4 aus Silbersulfid, also Ag₂S gebildet. Die Freilegung der Außenkontakte kann durch Ablation oder temporärer Abdeckung, beispielsweise durch eine Schutzschicht 11, erfolgen. Die Schutzschicht 11 kann beispielsweise ein Sulfid sein. Durch die Verwendung einer anorganischen Passivierungsschicht 4 in einem organischen lichtemittierenden Bauelement 100 kann der Abstand und/oder die Form und/oder die Breite der leitenden Stromaufweitungsstrukturen 3 variabel gestaltet werden und trotzdem eine homogene Leuchtfläche eingestellt werden. Die leitenden Stromaufweitungsstrukturen 3 sind sehr schmal in der Breite ausbildbar und damit quasi nicht sichtbar. Damit können viele leitende Stromaufweitungsstrukturen 3 aufgebracht werden, die zu einer verbesserten gleichmäßigen Abstrahlung der von dem organischen funktionellen Schichtenstapel 5 emittierten Strahlung beitragen. Der Überzug der leitenden Stromaufweitungsstrukturen 3 mit einer anorganischen Passivierungsschicht 4, welche insbesondere sehr dünn ausgeformt ist, ermöglicht eine verbesserte Aufbringung des organischen funktionellen Schichtenstapels 5. Gleichzeitig kann die erste Elektrode 2, die beispielsweise aus TCO geformt ist, behandelt werden und somit der Schichtwiderstand reduziert werden und die Austrittsarbeit verändert werden. Zudem unterbindet die anorganische Passivierungsschicht 4 einen direkten Stromfluss von der ersten Elektrode 2 in Richtung organischen funktionellen Schichtenstapels 5, beispielsweise in die Lochtransportschicht und/oder Lochinjektionsschicht, die vorzugsweise zwischen der ersten Elektrode 2 und dem organischen funktionellen Schichtenstapel 5 angeordnet sind.

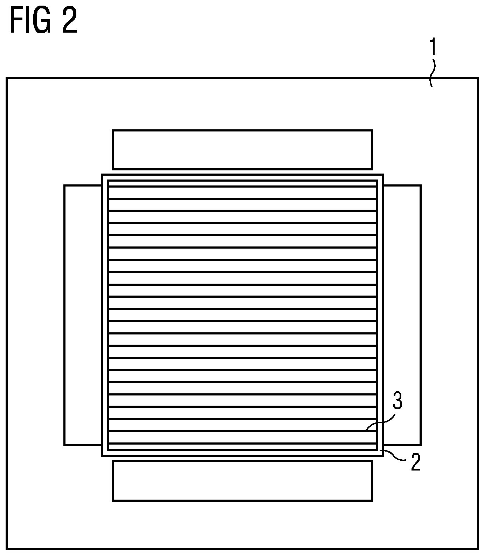

Die Figur 2 zeigt eine schematische Draufsicht eines Ausschnitts eines organischen lichtemittierenden Bauelements 100 gemäß einer Ausführungsform. Die Figur 2 zeigt die parallel zueinander verlaufenden Zuleitungsstrukturen der leitenden Stromaufweitungsstruktur 3 auf einer ersten Elektrode 2. Die parallel zueinander verlaufenden Zuleitungsstrukturen der leitenden Stromaufweitungsstruktur 3 können mit einer anorganischen Passivierungsschicht 4 bedeckt sein (hier nicht gezeigt).

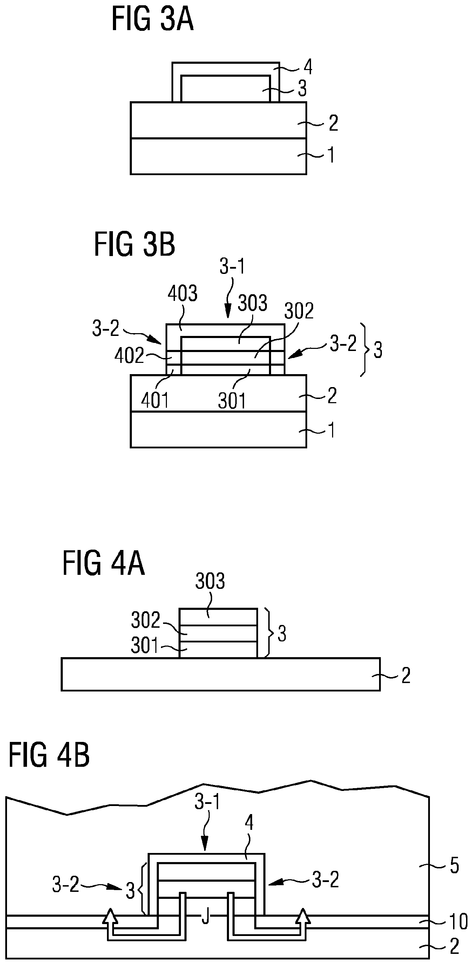

Die Figuren 3 bis 8 zeigen jeweils nur eine leitende Stromaufweitungsstruktur 3. Allerdings gilt hier Beschriebenes analog auch für mehr als eine leitende Stromaufweitungsstruktur 3. Die Figuren 2 bis 8 können ferner eine oder mehrere Lochtransportschichten und/oder Lochinjektionsschichten, insbesondere zwischen dem organischen funktionellen Schichtenstapel 5 und der Anode, und/oder eine oder mehrere Elektronentransportschichten und/oder Elektroneninjektionsschichten, insbesondere zwischen dem organischen funktionellen Schichtenstapel 5 und der Kathode, aufweisen (hier nicht gezeigt).

Figuren 3A und 3B zeigen jeweils einen schematischen Ausschnitt eines organischen lichtemittierenden Bauelements 100 gemäß einer Ausführungsform. Die Figur 3A zeigt ein Substrat 1 und nachgeordnet eine erste Elektrode 2, eine leitende Stromaufweitungsstruktur 3 und eine anorganische Passivierungsschicht 4. Das Substrat 1 kann beispielsweise aus Glas sein. Die erste Elektrode 2 ist insbesondere als Anode ausgeformt und transparent oder halbtransparent. Auf der ersten Elektrode 2 ist in direktem mechanischem Kontakt eine leitende Stromaufweitungsstruktur 3 angeordnet, die ein Metall aufweist oder aus einem Metall besteht. Die leitende Stromaufweitungsstruktur 3 ist hier allseitig, das heißt von allen Seiten, insbesondere von drei Seiten, von einer anorganischen Passivierungsschicht 4 überzogen. Die anorganische Passivierungsschicht 4 besteht oder weist dabei vorzugsweise das Sulfid des Metalls der leitenden Stromaufweitungsstruktur 3 auf. Ist beispielsweise die leitende Stromaufweitungsstruktur 3 aus Silber geformt, so weist die anorganische Passivierungsschicht 4 Silbersulfid als Material auf.

Figur 3B unterscheidet sich von der Figur 3A dadurch, dass die leitende Stromaufweitungsstruktur 3 einen Schichtaufbau 301, 302, 303 aufweist. Die Schichten der leitenden Stromaufweitungsstruktur weisen insbesondere unterschiedliche Metalle auf. Insbesondere weisen benachbarte Schichten unterschiedliche Metalle auf. Beispielsweise kann die untere Schicht 301 aus Silber, die Schicht 302 aus einem weiteren beliebigen Metall und die Schicht 303 aus Silber bestehen. Die anorganische Passivierungsschicht 4 weist damit ebenfalls eine unterschiedliche Zusammensetzung auf, insbesondere einen Schichtaufbau 401, 402, 403. Die anorganische Passivierungsschicht 4 weist dort, wo die Schicht 303 angeordnet ist, Silbersulfid, dort, wo die Schicht 302 angeordnet ist, ein Sulfid des Metall und dort, wo die Schicht 301 angeordnet ist, Silbersulfid auf. Damit kann eine anorganische Passivierungsschicht 4 erzeugt werden, die eine Mischung aus unterschiedlichen Sulfiden 401, 402, 403 der Metalle der leitenden Stromaufweitungsstruktur 3 aufweist.

Die Figuren 4A und 4B zeigen jeweils eine schematische Seitenansicht eines Ausschnitts eines organischen lichtemittierenden Bauelements 100 gemäß einer Ausführungsform. Die Figur 4A zeigt eine erste Elektrode 2, über die eine leitende Stromaufweitungsstruktur 3 angeordnet ist. Die leitende Stromaufweitungsstruktur 3 weist eine Schichtenfolge 301, 302, 303 auf. Die Figur 4B zeigt die erfolgte Sulfidisierung der leitenden Stromaufweitungsstruktur und damit die Ausbildung der anorganischen Passivierungsschicht 4 zumindest auf der Oberfläche 3-1 und an den Seitenflächen 3-2 der leitenden Stromaufweitungsstruktur 3. Durch die Ausbildung einer anorganischen Passivierungsschicht 4 kann ein direkter Stromfluss von der leitenden Stromaufweitungsstruktur 3 in den organischen funktionellen Schichtenstapel 5 verhindert werden, so dass der Stromfluss J über die erste Elektrode 2 in den organischen funktionellen Schichtenstapel 5 gelangt. Insbesondere ist dies der Fall, wenn die erste Elektrode 2 als Anode ausgeformt ist und die anorganische Passivierungsschicht 4 ein n-Halbleiter oder die erste Elektrode als Kathode ausgeformt ist und die anorganische Passivierungsschicht 4 ein p-Halbleiter ist. Die anorganische Passivierungsschicht 4 isoliert also die leitende Stromaufweitungsstruktur 3 und zumindest einen organischen funktionellen Schichtenstapel 5, verhindert also einen Lochtransport der von der Anode injizierten Löcher oder einen Elektronentransport der von der Kathoden injizierten Elektronen. Das Bauelement 100 kann eine weitere Schicht 10 aufweisen, die beispielsweise eine Löcherinjektionsschicht und/oder Lochtransportschicht ist. Anstelle eines Schichtaufbaus der leitenden Stromaufweitungsstruktur 3 kann diese auch einschichtig aus einem Metall, vorzugsweise Silber, sein.

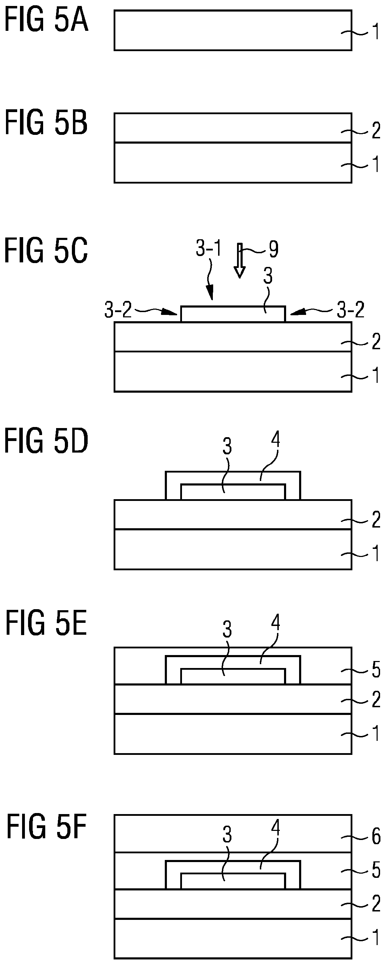

Die Figur 5 zeigt ein Verfahren zur Herstellung eines organischen lichtemittierenden Bauelements 100 gemäß einer Ausführungsform. Die Figur 5A zeigt die Bereitstellung eines Substrats 1. Auf dem Substrat 1 wird in der Figur 5B eine erste Elektrode 2 aufgebracht. Insbesondere wird die erste Elektrode 2 direkt auf das Substrat 1 aufgebracht. Figur 5C zeigt das Aufbringen zumindest einer leitenden Stromaufweitungsstruktur 3 auf die erste Elektrode 2. Die leitende Stromaufweitungsstruktur 3 weist eine dem Substrat abgewandte Oberfläche 3-1 und Seitenflächen 3-2 auf. Die leitende Stromaufweitungsstruktur 3 kann durch ganzflächiges Aufbringen des Materials der leitenden Stromaufweitungsstruktur 3 auf das Substrat 1 oder der ersten Elektrode 2 erzeugt werden. Alternativ oder zusätzlich kann die leitende Stromaufweitungsstruktur 3 auch nur selektiv auf die erste Elektrode 2 aufgebracht werden. Anschließend kann das Bauelement in der Figur 5C behandelt werden (dargestellt durch einen Pfeil 9). Die Behandlung 9 kann mit einer Schwefelwasserstoff umfassenden Atmosphäre, einerschwefelhaltigen oder schwefelionenhaltigen Lösung oder einem schwefelhaltigem oder schwefelionenhaltigem Plasma erfolgen. Dadurch wird, wie in Figur 5D gezeigt, eine anorganische Passivierungsschicht 4 ausgebildet. Die anorganische Passivierungsschicht 4 weist insbesondere Sulfide des Metalls oder der Legierung der leitenden Stromaufweitungsstruktur 3 auf. Es wird also kein zusätzliches Material auf die leitende Stromaufweitungsstruktur 3 aufgebracht, sondern die anorganische Passivierungsschicht 4 wird in situ aus der leitenden Stromaufweitungsstruktur 3 erzeugt. In Figur 5E wird anschließend ein organischer funktioneller Schichtenstapel 5 zumindest auf die anorganische Passivierungsschicht 4 und zumindest teilweise auf die erste Elektrode 2 aufgebracht. Anschließend erfolgt in der Figur 5F das Aufbringen einer zweiten Elektrode 6.

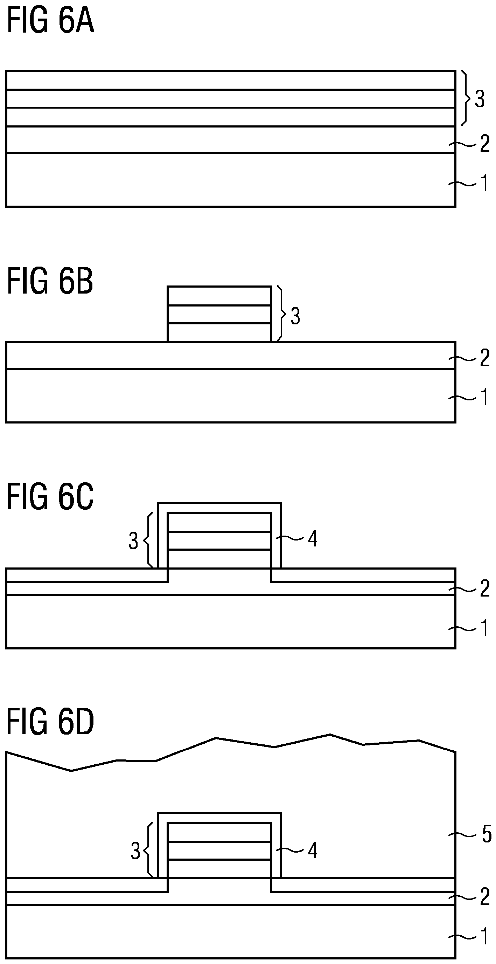

Die Figur 6 zeigt ein schematisches Verfahren zur Herstellung eines organischen lichtemittierenden Bauelements 100 gemäß einer Ausführungsform. Figur 6A zeigt das Bereitstellen eines Substrats 1 und einer ersten Elektrode 2. Auf dieser ersten Elektrode 2 wird ganzflächig und unstrukturiert ein Material für eine leitende Stromaufweitungsstruktur 3 aufgebracht. Anschließend erfolgt die Erzeugung der leitenden Stromaufweitungsstruktur 3, beispielsweise durch Ätzprozesse. Es resultiert zumindest eine leitende Stromaufweitungsstruktur 3 (Figur 6B). In der Figur 6C erfolgt anschließend die Behandlung zumindest der leitenden Stromaufweitungsstruktur 3 durch eine Schwefelwasserstoff umfassende Atmosphäre, eine schwefelionenhaltige Lösung und/oder einem schwefelionenhaltigem Plasma, so dass eine anorganische Passivierungsschicht 4 erzeugt wird. Die anorganische Passivierungsschicht 4 bildet sich selektiv auf den leitenden Stromaufweitungsstrukturen 3 aus und wirkt isolierend zumindest für Löcher oder Elektronen. Die anorganische Passivierungsschicht 4 ist insbesondere aus dem Sulfid des Metalls der leitenden Stromaufweitungsstruktur 3 gebildet. Figur 6D zeigt das Aufbringen des organischen funktionellen Schichtenstapels 5. Anstelle eines Schichtaufbaus der leitenden Stromaufweitungsstruktur 3 kann diese auch einschichtig aus einem Metall, vorzugsweise Silber, sein.

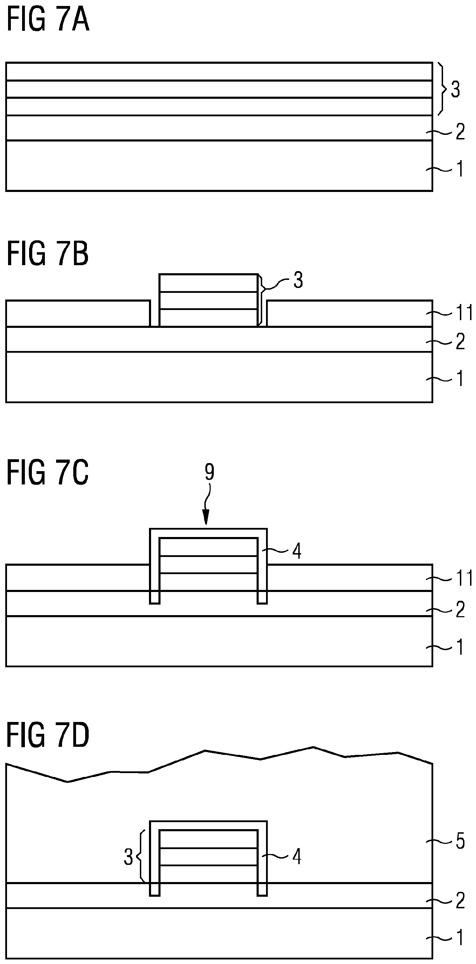

Figur 7 zeigt ein schematisches Verfahren zur Herstellung eines organischen lichtemittierenden Bauelements 100 gemäß einer Ausführungsform. In Figur 7A werden ein Substrat 1, eine zweite Elektrode 2 und ein ganzflächig auf die zweite Elektrode 2 aufgebrachtes Material für die leitende Stromaufweitungsstruktur 3 gezeigt. Anschließend erfolgt das Strukturieren des Materials zur Ausbildung einer leitenden Stromaufweitungsstruktur 3 (hier nicht gezeigt). Anschließend erfolgt das Aufbringen einer Schutzschicht 11, die insbesondere eine Oxid-, Selenid-, Tellurid- oder Sulfidschutzschicht ist, selektiv, also auf die freien Flächen der ersten Elektrode 2, welche nicht von der leitenden Stromaufweitungsstruktur 3 bedeckt sind. Damit wird die erste Elektrode 2 vor Sulfidisierung geschützt. Anschließend erfolgt in der Figur 7C die Behandlung 9 beispielsweise mittels Schwefelwasserstoff, wobei dann die leitende Stromaufweitungsstruktur 3 eine anorganische Passivierungsschicht 4 ausbildet. Aufgrund der Schutzschicht 11 wird die erste Elektrode 2, beispielsweise aus TCO, vor dieser Sulfidisierung geschützt. Anschließend kann die Schutzschicht 11 entfernt werden (hier nicht gezeigt) und der organische funktionelle Schichtenstapel 5 aufgebracht werden (Figur 7D). Anstelle eines Schichtaufbaus der leitenden Stromaufweitungsstruktur 3 kann diese auch einschichtig aus einem Metall, vorzugsweise Silber, sein.

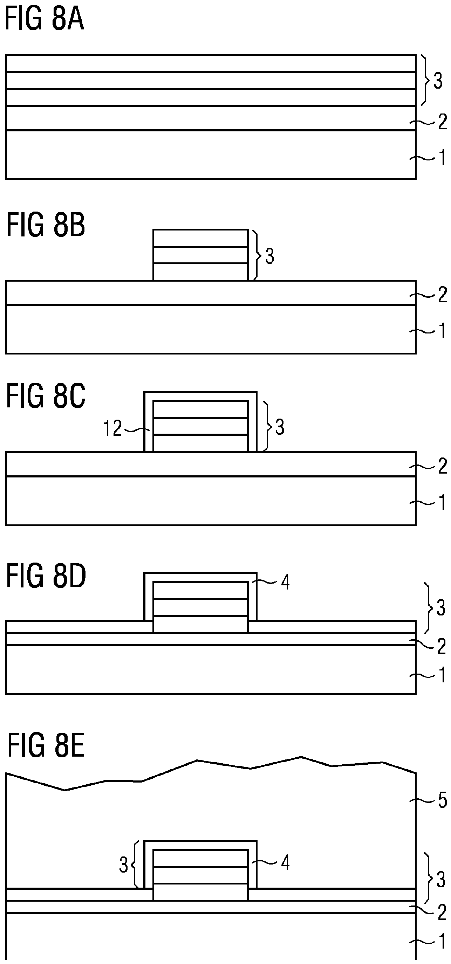

Die Figur 8 zeigt schematisch ein Verfahren zur Herstellung eines organischen lichtemittierenden Bauelements 100 gemäß einer Ausführungsform. Die Figuren 8A und 8B entsprechen den Figuren 6A und 6B. In der Figur 8C wird nun eine Metallschicht 12 zumindest auf die Oberfläche 3-1 und auf die Seitenflächen 3-2 der leitenden Stromaufweitungsstruktur 3 aufgebracht. In der Figur 8D wird diese Metallschicht 12 beispielsweise sulfidisiert oder telluridisiert, so dass sich aus der Metallschicht 12 durch Behandlung, beispielsweise mit Schwefelwasserstoff oder Tellurwasserstoff, eine anorganische Passivierungsschicht 4 bildet. Alternativ kann die Metallschicht auch nicht vollständig sulfidisiert oder telluridisiert werden, sondern nur teilweise, so dass die Metallschicht 12 noch vorhanden ist und direkt an der anorganischen Passivierungsschicht 4 angrenzt. Figur 8E entspricht der Figur 6D. Anstelle eines Schichtaufbaus der leitenden Stromaufweitungsstruktur 3 kann diese auch einschichtig aus einem Metall, vorzugsweise Silber, sein.

Die in den Figuren 3 bis 8 dargestellten Bauelemente 100 können zusätzlich eine Verkapselung 7 aufweisen.

Durch die Erfindung wird gleichzeitig die elektrisch leitfähige leitende Stromaufweitungsstruktur 3 gegenüber Löcher oder Elektronen isoliert, so dass kein direkter Stromfluss über die Passivierungsschicht 4 erfolgt und die Eigenschaften der ersten Elektrode 2, die beispielsweise aus ITO ist, zum niedrigen Widerstand verbessert. Zudem wird für die Verkapselung 7 eine dünnere zu überdeckende Struktur geschaffen.

Vorteil ist, dass die anorganische Passivierungsschicht 4 kompatibel zu Prozessen ist, die beeinflussend auf elektrooptische Parameter, Lagerzeit und/oder Langzeitstabilität sind.

Im vorgeschlagenen Prozess werden die geätzten und freigelegten Metallstrukturen (Kontakte, Busbars) behandelt, so dass sich eine anorganische Passivierungsschicht 4 ausbildet, die so dick ist, dass kein Tunnelstrom fließen kann. Damit ist kein zusätzlicher Resist mehr notwendig. Die Kontakte im Außenbereich können auch sulfidisiert oder telluridisiert werden, können dann aber durch zum Beispiel Ätz- oder Ablationsprozesse wieder freigelegt werden. Im Prinzip sind damit alle Kontakte behandelbar.

Die in Verbindung mit den Figuren beschriebenen Ausführungsbeispiele und deren Merkmale können gemäß weiterer Ausführungsbeispiele auch miteinander kombiniert werden, auch wenn solche Kombinationen nicht explizit in den Figuren gezeigt sind. Weiterhin können die in Verbindung mit den Figuren beschriebenen Ausführungsbeispiele zusätzliche oder alternative Merkmale gemäß der Beschreibung im allgemeinen Teil aufweisen.

Die Erfindung ist nicht durch die Beschreibung anhand der Ausführungsbeispiele auf diese beschränkt.

## Patentansprüche

1. Organisches lichtemittierendes Bauelement (100) aufweisend
- ein Substrat (1),
- eine erste Elektrode (2), die über dem Substrat (1) angeordnet ist,
- zumindest einen organischen funktionellen Schichtenstapel (5), der zur Emission von Strahlung eingerichtet und zumindest über der ersten Elektrode (2) angeordnet ist,
- zumindest eine leitende Stromaufweitungsstruktur (3), die auf der ersten Elektrode (2) angeordnet und dem organischen funktionellen Schichtenstapel (5) zugewandt ist,
wobei die leitende Stromaufweitungsstruktur (3) zumindest ein Metall aufweist,
wobei die leitende Stromaufweitungsstruktur (3) mit einer anorganischen Passivierungsschicht (4) überzogen ist, so dass die anorganische Passivierungsschicht ganzflächig die Seitenflächen und die Oberfläche der leitenden stromaufweitungsstruktur umhüllt oder bedeckt, wobei die anorganische Passivierungsschicht (4) ein Sulfid, Selenid und/oder Tellurid des zumindest einen Metalls der leitenden Stromaufweitungsstruktur (3) umfasst,
wobei die anorganische Passivierungsschicht (4) entweder ein n- oder ein p-Halbleiter ist, so dass kein Stromfluss zwischen der leitenden Stromaufweitungsstruktur (3) und dem organischen funktionellen Schichtenstapel (5) über die anorganische Passivierungsschicht (4) erfolgt, und
- eine zweite Elektrode (6), die über dem organischen funktionellen Schichtenstapel (5) angeordnet ist.

2. Organisches lichtemittierendes Bauelement (100) nach Anspruch 1,
wobei die anorganische Passivierungsschicht (4) durch Sulfidisierung des zumindest einen Metalls der leitenden Stromaufweitungsstruktur (3) erzeugt ist.

3. Organisches lichtemittierendes Bauelement (100) nach einem der vorhergehenden Ansprüche,
wobei die erste Elektrode (2) als Anode ausgeformt ist und die anorganische Passivierungsschicht (4) ein n-Halbleiter ist, so dass ein Löchertransport von der ersten Elektrode (2) über die anorganische Passivierungsschicht (4) in Richtung organischen funktionellen Schichtenstapel (5) unterbunden ist.

4. Organisches lichtemittierendes Bauelement (100) nach einem der vorhergehenden Ansprüche,
wobei die leitende Stromaufweitungsstruktur (3) Silber als Metall und die anorganische Passivierungsschicht (4) Silbersulfid umfasst.

5. Organisches lichtemittierendes Bauelement (100) nach einem der vorhergehenden Ansprüche,
das die von dem organischen funktionellen Schichtenstapel (5) erzeugte Strahlung über die erste Elektrode (2) und das Substrat (1) emittiert.

6. Organisches lichtemittierendes Bauelement (100) nach einem der vorhergehenden Ansprüche,
wobei die leitende Stromaufweitungsstruktur (3) Silber als Metall umfasst und die anorganische Passivierungsschicht (4) durch Telluridisierung zumindest des Silbers der leitenden Stromaufweitungsstruktur (3) erzeugt ist.

7. Organisches lichtemittierendes Bauelement (100) nach einem der vorhergehenden Ansprüche,
wobei die erste Elektrode (2) oder die zweite Elektrode (6) als Kathode ausgeformt ist und die anorganische Passivierungsschicht (4) ein p-Halbleiter ist, so dass ein Elektronentransport von der ersten Elektrode (2) oder der zweiten Elektrode (6) über die anorganische Passivierungsschicht (4) in Richtung organischen funktionellen Schichtenstapel (5) unterbunden ist.

8. Organisches lichtemittierendes Bauelement (100) nach dem vorhergehenden Anspruch,
wobei die zweite Elektrode (6) als Kathode ausgeformt ist und die von dem organischen funktionellen Schichtenstapel (5) erzeugte Strahlung sowohl über die erste Elektrode (2) als auch über die zweite Elektrode (6) emittiert.

9. Organisches lichtemittierendes Bauelement (100) nach einem der vorhergehenden Ansprüche,
wobei die anorganische Passivierungsschicht (4) eine Mischung von zumindest zwei unterschiedlichen Metallsulfiden ist.

10. Organisches lichtemittierendes Bauelement (100) nach einem der vorhergehenden Ansprüche,
wobei die anorganische Passivierungsschicht (4) eine Schichtdicke zwischen einschließlich 10 nm und 100 nm aufweist.

11. Organisches lichtemittierendes Bauelement (100) nach einem der vorhergehenden Ansprüche,
wobei die leitende Stromaufweitungsstruktur (3) eine dem Substrat (1) abgewandte Oberfläche (3-1) und Seitenflächen (3-2) aufweist, wobei die anorganische Passivierungsschicht (4) sowohl die Oberfläche (3-1) als auch die Seitenflächen (3-2) direkt bedeckt.

12. Organisches lichtemittierendes Bauelement (100) nach einem der vorhergehenden Ansprüche,
wobei die leitende Stromaufweitungsstruktur (3) eine Metallschicht (12) umfasst, die eine dem Substrat (1) abgewandte Oberfläche (3-1) und Seitenflächen (3-2) der leitenden Stromaufweitungsstruktur (3) direkt bedeckt, wobei die anorganische Passivierungsschicht (4) durch Sulfidisierung der Metallschicht (12) erzeugt ist und zumindest die Oberfläche (3-1) und die Seitenflächen (3-2) der leitenden Stromaufweitungsstruktur (3) bedeckt.

13. Organisches lichtemittierendes Bauelement (100) nach dem vorhergehenden Anspruch,
wobei die Metallschicht (12) Silber und die anorganische Passivierungsschicht (4) Silbersulfid umfasst.

14. Verfahren zur Herstellung eines organischen lichtemittierenden Bauelements nach einem der Ansprüche 1 bis 13, mit den Schritten:
A) Bereitstellen eines Substrats (1),
B) Aufbringen einer ersten Elektrode (2) auf das Substrat (1),
C) Aufbringen zumindest einer leitenden Stromaufweitungsstruktur (3) auf die erste Elektrode (2), wobei die leitende Stromaufweitungsstruktur (3) zumindest ein Metall und eine dem Substrat (1) abgewandte Oberfläche (3-1) und Seitenflächen (3-2) aufweist,
D) selektive Ausbildung einer anorganischen Passivierungsschicht (4) zumindest auf der Oberfläche (3-1) und den Seitenflächen (3-2) der leitenden Stromaufweitungsstruktur (3), wobei die anorganische Passivierungsschicht (4) ein Sulfid, Tellurid und/oder Selenid des zumindest einen Metalls der leitenden Stromaufweitungsstruktur (3) umfasst und die leitende Stromaufweitungsstruktur (3) mit der anorganischen Passivierungsschicht (4) überzogen wird, so dass die anorganische Passivierungsschicht ganzflächig die Seitenflächen und die Oberfläche der leitenden stromaufweitungsstruktur umhüllt oder bedeckt, wobei die anorganische Passivierungsschicht (4) entweder ein n- oder ein p-Halbleiter ist, so dass kein Stromfluss zwischen der leitenden Stromaufweitungsstruktur (3) und dem organischen funktionellen Schichtenstapel (5) über die anorganische Passivierungsschicht (4) erfolgt,
E) Aufbringen eines organischen funktionellen Schichtenstapels (5) zumindest auf die anorganische Passivierungsschicht (4) und zumindest teilweise auf die erste Elektrode (2), und
F) Aufbringen einer zweiten Elektrode (6).

15. Verfahren nach Anspruch 14,
wobei vor Schritt D) ein zusätzlicher Schritt C1) erfolgt:
C1) Selektives Aufbringen einer Schutzschicht (11) auf Bereiche der ersten Elektrode (2), die frei von der leitenden Stromaufweitungsstruktur (3) sind, und wobei nach Schritt D) ein zusätzlicher Schritt D1) erfolgt:
D1) Entfernen der Schutzschicht (11).

16. Verfahren nach einem der Ansprüche 14 bis 15, wobei Schritt D) mittels einer Schwefelwasserstoff umfassenden Atmosphäre, einer schwefelhaltigen Lösung oder einem schwefelhaltigem Plasma durchgeführt wird.

## Claims

1. Organic light-emitting device (100) comprising
- a substrate (1),
- a first electrode (2) arranged above the substrate (1),
- at least one organic functional layer stack (5) which is configured to emit radiation and is arranged at least above the first electrode (2),
- at least one conductive current spreading structure (3) arranged on the first electrode (2) and facing the organic functional layer stack (5),
wherein the conductive current spreading structure (3) comprises at least one metal,
wherein the conductive current spreading structure (3) is coated with an inorganic passivation layer (4) so that the inorganic passivation layer coats or covers the side faces and the surface of the conductive current spreading structure over the entire area,
wherein the inorganic passivation layer (4) comprises a sulfide, selenide and/or telluride of the at least one metal of the conductive current spreading structure (3),
wherein the inorganic passivation layer (4) is either an n-type or a p-type semiconductor so that no current flow occurs between the conductive current spreading structure (3) and the organic functional layer stack (5) via the inorganic passivation layer (4), and
- a second electrode (6) arranged above the organic functional layer stack (5).

2. Organic light-emitting device (100) according to claim 1, wherein the inorganic passivation layer (4) is produced by sulfidizing the at least one metal of the conductive current spreading structure (3).

3. Organic light-emitting device (100) according to one of the preceding claims,
wherein the first electrode (2) is formed as an anode and the inorganic passivation layer (4) is an n-type semiconductor, so that a hole transport from the first electrode (2) via the inorganic passivation layer (4) in direction of the organic functional layer stack (5) is prevented.

4. Organic light-emitting device (100) according to one of the preceding claims,
wherein the conductive current spreading structure (3) comprises silver as metal and the inorganic passivation layer (4) comprises silver sulfide.

5. Organic light-emitting device (100) according to one of the preceding claims,
which emits the radiation generated by the organic functional layer stack (5) via the first electrode (2) and the substrate (1) .

6. Organic light-emitting device (100) according to one of the preceding claims,
wherein the conductive current spreading structure (3) comprises silver as the metal and the inorganic passivation layer (4) is produced by telluridization of at least the silver of the conductive current spreading structure (3).

7. Organic light-emitting device (100) according to one of the preceding claims,
wherein the first electrode (2) or the second electrode (6) is formed as cathode and the inorganic passivation layer (4) is a p-type semiconductor, so that electron transport from the first electrode (2) or the second electrode (6) via the inorganic passivation layer (4) in direction of the organic functional layer stack (5) is prevented.

8. Organic light-emitting device (100) according to the preceding claim,
wherein the second electrode (6) is formed as a cathode and emits the radiation generated by the organic functional layer stack (5) both via the first electrode (2) and via the second electrode (6).

9. Organic light-emitting device (100) according to one of the preceding claims,
wherein the inorganic passivation layer (4) is a mixture of at least two different metal sulfides.

10. Organic light-emitting device (100) according to one of the preceding claims,
wherein the inorganic passivation layer (4) has a layer thickness between 10 nm and 100 nm inclusive.

11. Organic light-emitting device (100) according to one of the preceding claims,
wherein the conductive current spreading structure (3) has a surface (3-1) facing away from the substrate (1) and side faces (3-2), wherein the inorganic passivation layer (4) directly covering both the surface (3-1) and the side faces (3-2) .

12. Organic light-emitting device (100) according to one of the preceding claims,
wherein the conductive current spreading structure (3) comprises a metal layer (12) directly covering a surface (3-1) facing away from the substrate (1) and side faces (3-2) of said conductive current spreading structure (3), wherein the inorganic passivation layer (4) is produced by sulfidizing the metal layer (12) and covers at least the surface (3-1) and the side faces (3-2) of the conductive current spreading structure (3).

13. Organic light-emitting device (100) according to the preceding claim,
wherein the metal layer (12) comprises silver and the inorganic passivation layer (4) comprises silver sulfide.

14. Method for producing an organic light-emitting device according to one of claims 1 to 13, comprising the steps of:
A) providing a substrate (1),
B) applying a first electrode (2) to the substrate (1),
C) applying at least one conductive current spreading structure (3) to the first electrode (2), wherein the conductive current spreading structure (3) comprising at least one metal and having a face (3-1) facing away from the substrate (1) and side faces (3-2),
D) selectively forming an inorganic passivation layer (4) at least on the surface (3-1) and the side faces (3-2) of the conductive current spreading structure (3), wherein the inorganic passivation layer (4) comprises a sulfide, telluride and/or selenide of the at least one metal of the conductive current spreading structure (3) and the conductive current spreading structure (3) is coated with the inorganic passivation layer (4) so that the inorganic passivation layer coats or covers the entire surface of the side faces and the surface of the conductive current spreading structure, wherein the inorganic passivation layer (4) is either an n-type or a p-type semiconductor, so that no current flow occurs between the conductive current spreading structure (3) and the organic functional layer stack (5) via the inorganic passivation layer (4),
E) applying an organic functional layer stack (5) at least on the inorganic passivation layer (4) and at least partially on the first electrode (2), and
F) applying a second electrode (6).

15. Method according to claim 14,
wherein an additional step C1) is performed before step D):
C1) selective application of a protective layer (11) to regions of the first electrode (2) which are free from the conductive current spreading structure (3), and wherein after step D) an additional step D1) takes place:
D1) removing the protective layer (11).

16. Method according to one of claims 14 to 15,
wherein step D) is performed by means of an atmosphere comprising hydrogen sulfide, a sulfur-containing solution or a sulfur-containing plasma.

## Revendications

1. Dispositif organique émetteur de lumière (100) comprenant
- un substrat (1),
- une première électrode (2) disposée au-dessus du substrat (1),
- au moins une pile de couches fonctionnelles organiques (5) qui est configurée pour émettre un rayonnement et qui est disposée au moins au-dessus de la première électrode (2),
- au moins une structure conductrice de propagation du courant (3) disposée sur la première électrode (2) et faisant face à la pile de couches fonctionnelles organiques (5),
dans laquelle la structure conductrice de propagation du courant (3) comprend au moins un métal,
dans laquelle la structure conductrice de propagation du courant (3) est revêtue d'une couche de passivation inorganique (4) de sorte que la couche de passivation inorganique recouvre ou recouvre les faces latérales et la surface de la structure conductrice de diffusion du courant sur toute la surface,
dans laquelle la couche de passivation inorganique (4) comprend un sulfure, un séléniure et/ou un tellurure d'au moins un métal de la structure conductrice de propagation du courant (3),
dans lequel la couche de passivation inorganique (4) est un semi-conducteur de type n ou de type p, de sorte qu'aucun flux de courant ne se produit entre la structure conductrice de propagation du courant (3) et la pile de couches fonctionnelles organiques (5) via la couche de passivation inorganique (4), et
- une deuxième électrode (6) disposée au-dessus de la pile de couches fonctionnelles organiques (5).

2. Dispositif organique émetteur de lumière (100) selon la revendication 1,
dans laquelle la couche de passivation inorganique (4) est produite par sulfuration d'au moins un métal de la structure conductrice de propagation du courant (3).

3. Dispositif organique émetteur de lumière (100) selon l'une des revendications précédentes,
dans laquelle la première électrode (2) est formée comme une anode et la couche de passivation inorganique (4) est un semi-conducteur de type n, de sorte qu'un transport de trous de la première électrode (2) via la couche de passivation inorganique (4) en direction de la pile de couches fonctionnelles organiques (5) est empêché.

4. Dispositif organique d'émission de lumière (100) selon l'une des revendications précédentes,
dans laquelle la structure conductrice de propagation du courant (3) comprend de l'argent comme métal et la couche de passivation inorganique (4) comprend du sulfure d'argent.

5. Dispositif organique émetteur de lumière (100) selon l'une des revendications précédentes,
qui émet le rayonnement généré par la pile de couches fonctionnelles organiques (5) via la première électrode (2) et le substrat (1).

6. Dispositif organique émetteur de lumière (100) selon l'une des revendications précédentes,
dans laquelle la structure conductrice de propagation du courant (3) comprend de l'argent comme métal et la couche de passivation inorganique (4) est produite par tellurisation d'au moins l'argent de la structure conductrice de propagation du courant (3).

7. Dispositif organique émetteur de lumière (100) selon l'une des revendications précédentes,
dans laquelle la première électrode (2) ou la deuxième électrode (6) est formée comme cathode et la couche de passivation inorganique (4) est un semi-conducteur de type p, de sorte que le transport d'électrons de la première électrode (2) ou de la deuxième électrode (6) via la couche de passivation inorganique (4) en direction de la pile de couches fonctionnelles organiques (5) est empêché.

8. Dispositif organique d'émission de lumière (100) selon la revendication précédente,
dans laquelle la deuxième électrode (6) est formée comme une cathode et émet le rayonnement généré par l'empilement de couches fonctionnelles organiques (5) à la fois par la première électrode (2) et par la deuxième électrode (6).

9. Dispositif organique d'émission de lumière (100) selon l'une des revendications précédentes,
dans laquelle la couche de passivation inorganique (4) est un mélange d'au moins deux sulfures métalliques différents.

10. Dispositif organique émetteur de lumière (100) selon l'une des revendications précédentes,
dans laquelle la couche de passivation inorganique (4) a une épaisseur de couche comprise entre 10 nm et 100 nm inclus.

11. Dispositif organique émetteur de lumière (100) selon l'une des revendications précédentes,
dans laquelle la structure conductrice de propagation du courant (3) présente une surface (3-1) tournée à l'opposé du substrat (1) et des faces latérales (3-2), dans laquelle la couche de passivation inorganique (4) recouvre directement à la fois la surface (3-1) et les faces latérales (3-2).

12. Dispositif organique d'émission de lumière (100) selon l'une des revendications précédentes,
dans lequel la structure conductrice de propagation du courant (3) comprend une couche métallique (12) recouvrant directement une surface (3-1) orientée à l'opposé du substrat (1) et des faces latérales (3-2) de la structure conductrice de propagation du courant (3), dans lequel la couche de passivation inorganique (4) est produite par sulfuration de la couche métallique (12) et recouvre au moins la surface (3-1) et les faces latérales (3-2) de la structure conductrice de propagation du courant (3).

13. Dispositif organique émetteur de lumière (100) selon la revendication précédente,
dans laquelle la couche métallique (12) comprend de l'argent et la couche de passivation inorganique (4) comprend du sulfure d'argent.

14. Procédé de fabrication d'un dispositif organique émetteur de lumière selon l'une des revendications 1 à 13, comprenant les étapes suivantes
A) fournir un substrat (1),
B) appliquer une première électrode (2) sur le substrat (1),
C) appliquer au moins une structure conductrice de propagation de courant (3) sur la première électrode (2), dans laquelle la structure conductrice de propagation de courant (3) comprend au moins un métal et a une face (3-1) tournée à l'opposé du substrat (1) et des faces latérales (3-2),
D) former sélectivement une couche de passivation inorganique (4) au moins sur la surface (3-1) et les faces latérales (3-2) de la structure conductrice de propagation du courant (3), dans laquelle la couche de passivation inorganique (4) comprend un sulfure, tellurure et/ou séléniure d'au moins un métal de la structure conductrice de propagation du courant (3) et la structure conductrice de propagation du courant (3) est revêtue de la couche de passivation inorganique (4) de sorte que la couche de passivation inorganique recouvre ou recouvre toute la surface des faces latérales et la surface de la structure conductrice de diffusion du courant,
dans lequel la couche de passivation inorganique (4) est un semi-conducteur de type n ou de type p, de sorte qu'aucun flux de courant ne se produit entre la structure conductrice de propagation du courant (3) et la pile de couches fonctionnelles organiques (5) via la couche de passivation inorganique (4),
E) appliquer un empilement de couches fonctionnelles organiques (5) au moins sur la couche de passivation inorganique (4) et au moins partiellement sur la première électrode (2), et
F) appliquer une deuxième électrode (6).

15. Méthode selon la revendication 14,
dans laquelle une étape supplémentaire C1) est effectuée avant l'étape D):
C1) application sélective d'une couche de protection (11) sur des régions de la première électrode (2) qui sont exemptes de la structure conductrice de propagation du courant (3), et dans laquelle, après l'étape D), une étape supplémentaire D1) a lieu :
D1) élimination de la couche de protection (11).

16. Méthode selon l'une des revendications 14 à 15,
dans laquelle l'étape D) est réalisée au moyen d'une atmosphère comprenant du sulfure d'hydrogène, une solution contenant du soufre ou un plasma contenant du soufre.
